# EUROPEAN PATENT APPLICATION

(11) **EP 1 916 711 A2**
(43) Date of publication of application: **30.04.2008**
(21) Application number: 07019972.4
(22) Date of filing: 11.10.2007
(51) Int. Cl.: H01L 23/29, H01L 23/31, H01L 21/56

(54) **Electronic device and method of manufacturing the same**

(30) Priority: 23.10.2006 JP 2006287635
(71) Applicant: NEC Electronics Corporation, Kawasaki, Kanagawa 211-8668 (JP)
(72) Inventor: Kakuta, Yuji, Kawasaki Kanagawa 211-8668 (JP); Mizutani, Hiroshi, Kawasaki Kanagawa 211-8668 (JP)
(74) Representative: Glawe, Delfs, Moll

(57) **Abstract**

An electronic device that enables securing excellent hollow structure and close air-tightness of the space between the substrate and the electronic component, without incurring degradation in production efficiency, is to be provided. The electronic device includes a mounting substrate, an electronic component mounted on the mounting substrate, and a resin film provided all over the mounting substrate, so as to cover the electronic component. The resin film has a shear viscosity equal to or more than 100 kPa·s and equal to or less than 1000 kPa·s and a flow length equal to or more than 100 µm and equal to or less than 1500 µm.

## Description

This application is based on Japanese patent application No.2006-287635, the content of which is incorporated hereinto by reference.

### BACKGROUND

### TECHNICAL FIELD

The present invention relates to an electronic device, and to a method of manufacturing the same.

### RELATED ART

The never-ending demand for higher performance, higher quality, smaller dimensions, and lower cost of semiconductor devices has made it essential to improve not only the semiconductor device itself, but also the container that covers the device. In the microwave region exceeding 20 GHz in particular, it is quite difficult to achieve the both of sufficient electrical performance and air-tightness of the container, and smaller dimensions and a low assembly cost thereof, and therefore realizing a container made of an inexpensive resin material but which offers sufficient quality and performance for use in the microwave region is expected to be a real breakthrough that dramatically expands the applicable fields.

Generally, an electromagnetic wave of a higher frequency suffers greater energy attenuation while propagating through a substance. Accordingly, in a high-frequency equipment such as a BS/CS broadcasting equipment, a microwave communication equipment or a radar equipment, it is a common practice to employ a container that air-tightly seals in vacuum an electrode of a semiconductor device and a wire bonding portion led out from the electrode. To produce such vacuum portion in fine dimensions, the device is flip-chip mounted on a mounting substrate, with the electrode portion of the device opposing the mounting substrate. Also, a device integrally including the container and the chip has been proposed, to secure the air-tightness with an inexpensive material. A synthetic resin film is overlaid on the entire semiconductor device that has been flip-chip mounted, and cured under a high temperature and high pressure.

Fig. 6 is a cross-sectional view of an electronic device disclosed in JP-A No.2005-505939. To manufacture the electronic device, firstly a resin film 103 is laminated over the back surface of an electronic component 102, which is flip-chip mounted on a substrate 101. Then the resin film 103 is removed from a closed stripe region around the electronic component 102. In this process, the interval between the stripe region and the electronic component 102 is selected so as to ensure that an edge portion of the laminated resin remains therebetween, to thereby allow the resin film 103 to be connected to the substrate 101 at that location. In the subsequent step a fluidized synthetic resin is provided, so as to form a resin layer 104.

Prior art related to the present invention includes JP-A No.2003-234633, in addition to JP-A No.2005-505939.
[Patented document 1] JP-A No.2005-505939
[Patented document 2] JP-A No.2003-234633

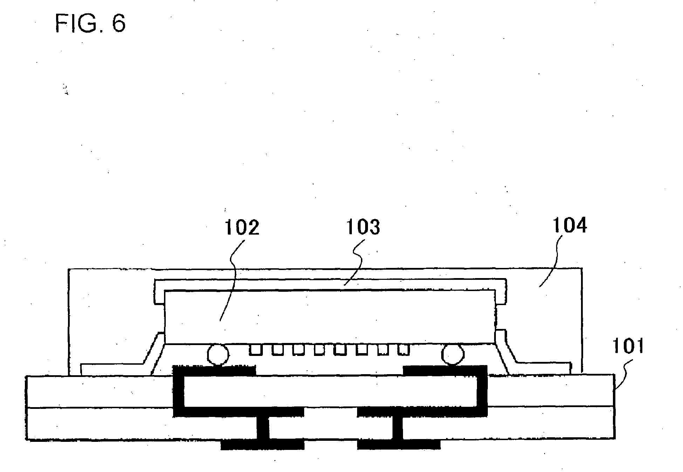

In the high-frequency equipment such as a BS/CS broadcasting equipment, a microwave communication equipment or a radar equipment, however, a majority of the chips (electronic components) is of a fine size such as 0.3 mm□. Accordingly, highly precise micro processing is required to remove the resin film 103 from the closed stripe region around the electronic component 102, while ensuring that the edge portion of the laminated resin remains around the electronic component 102, as is the case with the electronic device shown in Fig. 6.

Further, in the case of consumer-oriented products such as the BS broadcasting equipment, the annual production quantity reaches as many as several hundreds of millions of pieces, and hence the assembly of the device has to be collectively executed in a massive quantity, from the viewpoint of production efficiency and economical advantage. Partially removing the resin film once laminated on the substrate requires an extra process and an exclusive processing apparatus, which incurs a large amount of investment in proportion to the production quantity. Nevertheless, in the electronic device shown in Fig. 6, removing the film in stripe patterns is indispensable, because otherwise close contact cannot be achieved between the additionally applied synthetic resin material and the supporting substrate, which results in failure in providing a complete sealing effect against moisture and stain.

### SUMMARY

In one embodiment, there is provided an electronic device comprising a substrate; an electronic component mounted on the substrate; and a resin film provided over an entirety of the substrate so as to cover the electronic component; wherein the resin film has a shear viscosity of equal to or more than 100 kPa·s and equal to or less than 1000 kPa·s at the temperature of 50 degrees centigrade, and a flow length equal to or more than 100 µm and equal to or less than 1500 µm at the temperature of 50 degrees centigrade.

In another embodiment, there is provided a method of manufacturing an electronic device comprising mounting an electronic component on a substrate; providing a resin film over an entirety of the substrate so as to cover the electronic component; wherein the step of providing a resin film includes employing a resin film having a shear viscosity equal to or more than 100 kPa·s and equal to or less than 1000 kPa·s at the temperature of 50 degrees centigrade, and a flow length equal to or more than 100 µm and equal to or less than 1500 µm at the temperature of 50 degrees centigrade.

In the electronic device thus constructed, the resin film that covers the electronic component is provided all over the substrate. Such structure eliminates the need to execute the micro processing to partially remove the resin film. Besides, the resin film has a shear viscosity equal to or more than 100 kPa·s and equal to or less than 1000 kPa·s at the temperature of 50 degrees centigrade, and a flow length equal to or more than 100 µm and equal to or less than 1500 µm at the temperature of 50 degrees centigrade. Employing such resin enables achieving excellent hollow structure and close air-tightness of the space between the substrate and the electronic component.

Thus, the present invention provides an electronic device that enables securing excellent hollow structure and close air-tightness of the space between the substrate and the electronic component, without incurring degradation in production efficiency, and a method of manufacturing such electronic device.

### BRIEF DESCRIPTION OF THE DRAWINGS

The above and other objects, advantages and features of the present invention will be more apparent from the following description of certain preferred embodiments taken in conjunction with the accompanying drawings, in which:
Fig. 1 is a cross-sectional view of an electronic device according to an embodiment of the present invention;
Figs. 2A to 2C are cross-sectional views sequentially showing a method of manufacturing the electronic device, according to an embodiment of the present invention;
Figs. 3A and 3B are cross-sectional views sequentially showing a method of manufacturing the electronic device, according to the embodiment;
Fig. 4 is a plan view showing a collective substrate on which a plurality of electronic components is mounted;
Fig. 5 is a graph showing a desirable range of shear viscosity and flow length of a resin film;
Fig. 6 is a cross-sectional view of a conventional electronic device; and
Fig. 7 is a cross-sectional view of another conventional electronic device.

### DETAILED DESCRIPTION

The invention will be now described herein with reference to illustrative embodiments. Those skilled in the art will recognize that many alternative embodiments can be accomplished using the teachings of the present invention and that the invention is not limited to the embodiments illustrated for explanatory purposes.

Hereunder, an exemplary embodiment of an electronic device and a method of manufacturing the same according to the present invention will be described referring to the accompanying drawings. In all the drawings, same constituents are given the same numerals, and the description thereof will not be repeated.

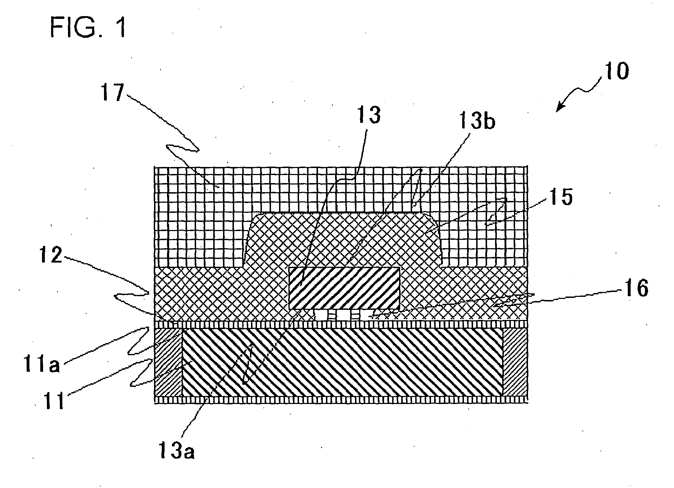

Fig. 1 is a cross-sectional view of an electronic device according to an embodiment of the present invention. The electronic device 10 includes a mounting substrate 11, an electronic component 13 mounted on the mounting substrate 11, and a resin film 15 provided all over the mounting substrate 11, so as to cover the electronic component 13. The resin film 15 has a shear viscosity equal to or more than 100 kPa·s and equal to or less than 1000 kPa·s at the temperature of 50 degrees centigrade and a flow length equal to or more than 100 µm and equal to or less than 1500 µm at the temperature of 50 degrees centigrade, and more preferably a shear viscosity equal to or more than 150 kPa ·s at the temperature of 50 degrees centigrade and equal to or less than 600 kPa·s at the temperature of 50 degrees centigrade and a flow length equal to or more than 100 µm and equal to or less than 1200 µm at the temperature of 50 degrees centigrade. On the resin film 15, an outer coating resin 17 (resin layer) is provided. While the resin film 15 includes a protruding portion (at a position corresponding to the electronic component 13), the outer coating resin 17 has a flat upper surface.

To be more detailed, in the electronic device 10 the mounting substrate 11 has a connection electrode exposed on one of its faces 11a; the electronic component 13 has a conductor pattern on one of its faces 13a, and is oriented such that the face 13a having the conductor pattern opposes the face 11a of the mounting substrate 11, and that the conductor pattern is both electrically connected and mechanically coupled to a connection electrode 12 of the mounting substrate 11; and the resin film 15 is adhered to the mounting substrate 11, so as to cover the electronic component 13 and the mounting substrate 11, and to achieve close contact with a face 13b of the electronic component 13 opposite to the mounting substrate 11 and a region of the face 11a of the mounting substrate 11 around the electronic component 13. Further on the resin film 15, the outer coating resin 17 with the flat upper surface is provided so as to cover the resin film 15.

The mounting substrate 11 may be made of a dielectric material such as an alumina ceramic or LTCC, a resin material such as Teflon® or glass epoxy, or a highly flexible material. The mounting substrate 11 has a thickness of, for example, 200 µm. The electronic component 13 may be a GaAs FET, an oscillator, or a high-frequency circuit, but not limited to those electronic component. The electronic component 13 is, as already stated, mounted on the mounting substrate 11 by a face-down bonding method such that the surface with the conductor pattern 13a opposes the mounting substrate 11. One of the surfaces 13a of the electronic component 13 and one of the surfaces 11a of the mounting substrate 11 define a space 16.

The surface 13b of the electronic component 13 opposite to the mounting substrate 11 is covered with the resin film 15 without a gap. A region of the surface 11a of the mounting substrate 11 around the electronic component 13 is also covered with the resin film 15 without a gap. The resin film 15 encapsulates the entirety of the electronic component 13, including the points of electrical connection with the conductor pattern of the electronic component 13 and the connection electrode of the mounting substrate 11.

The resin film 15 may be constituted of a thermosetting resin such as an epoxy resin (epoxy/phenol/silica/acrylic acid ester). The resin film 15 has a thickness of 150 µm for example, and the flow length at 50°C is not greater than 1, 200 µm. The outer coating resin 17 may be constituted of a thermosetting resin such as an epoxy resin. The outer coating resin 17 has a thickness of, for example, 400 µm.

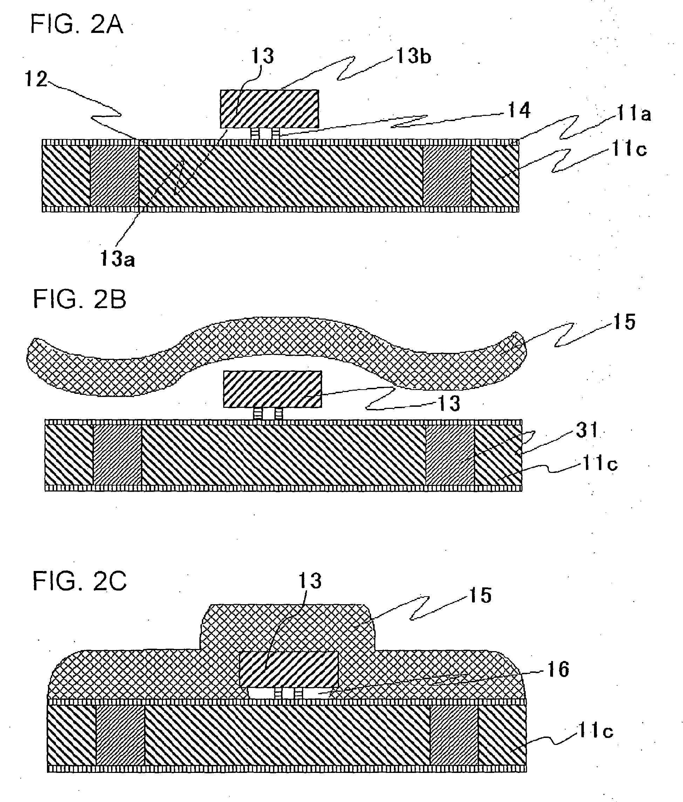

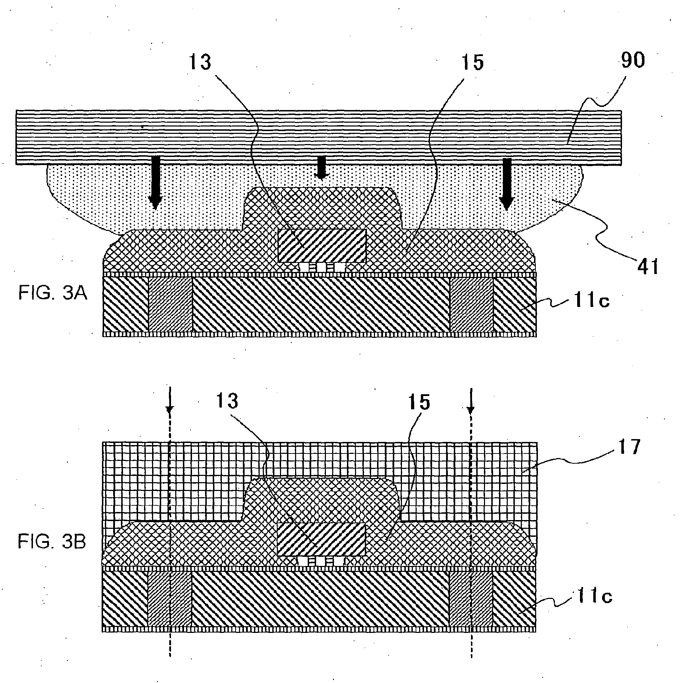

Referring to Figs. 2A to 3B, a method of manufacturing the electronic device 10 will described, as an embodiment of the method of manufacturing an electronic device according to the present invention. In short, the manufacturing method includes a step of mounting the electronic component 13 on the mounting substrate 11, and a step of providing the resin film 15 all over the substrate 11 so as to cover the electronic component 13.

To be more detailed, the manufacturing method includes a step of disposing first the electronic component 13 against a collective substrate 11c that includes a plurality of sections to be split into each mounting substrate 11 such that one of the surfaces 13a of the electronic component 13 opposes the surface 11a of the mounting substrate 11, and then electrically and mechanically connecting the conductor pattern on the electronic component 13 to the connection electrode of the mounting substrate 11 (Fig. 2A) , and a step of disposing the resin film 15 so as to cover the electronic component 13 and the mounting substrate 11 and to achieve close contact with the surface 13b of the electronic component 13 opposite to the mounting substrate 11 and the region of the surface 11a of the mounting substrate 11 around the electronic component 13, and bonding the resin film 15 to the mounting substrate 11 (Figs. 2B and 2C).

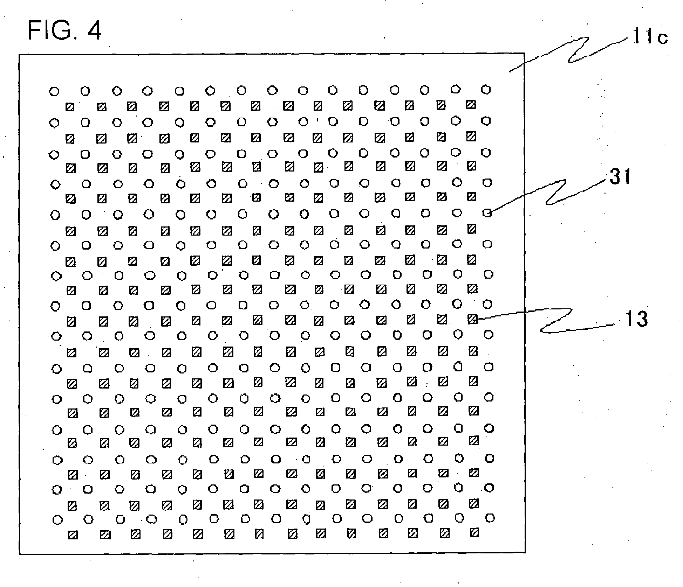

Fig. 4 is a plan view of the collective substrate 11c. On the collective substrate 11c a plurality of electronic components 13 is mounted, and the resin film 15 is provided so as to collectively cover the plurality of electronic components 13. The collective substrate 11c includes a plurality of holes 31 around the region where each of the electronic components 13 is to be located. The hole 31 may be provided at two opposite positions across the electronic component 13, or at four positions outside of the four sides of the electronic component 13. The hole 31 may be filled with a metal conductor such as gold. The foregoing processes are performed with the collective substrate 11c placed on a supporting member with a flat upper surface.

By the manufacturing method according to this embodiment, the resin film 15 may be heat up to approx. 50°C for example so as to soften the resin film 15, and the resin film 15 may be deformed so as to cover the electronic component 13 and the mounting substrate 11 achieving uniformly close contact with the surface 13b of the electronic component 13 opposite to the mounting substrate 11 and the region of the surface 11a of the mounting substrate 11 around the electronic component 13. In this process, the space between the resin film 15 and the mounting substrate 11 may be set under a negative pressure of not exceeding 50Pa so as to depressurize the gas in this space, and an elastic pressing tool made of rubber or the like may be employed to press the entirety of the resin film 15 from an upper direction against the mounting substrate 11' including the electronic component 13, at a pressure of 0.5 MPa so that the resin film 15 makes close contact with the mounting substrate 11 and the electronic component 13. The pressure and the temperature are retained as they are until the resin film 15 restores sufficient viscosity, and then returned normal temperature and pressure.

Then the resin film 15 may be heated, for example, up to approx. 170°C for curing, so as to bond the resin film 15 to the mounting substrate 11 and fix the shape of the resin film 15. When the resin film 15 is cured, a shrinking force is generated. The shrinking force of the resin film 15 acts in a direction to press the electronic component 13 against the mounting substrate 11. This process further assures the mechanical adhesion of the conductor pattern of the electronic component 13 and the connection electrode of the mounting substrate 11. Further, the shrinkage of the resin film 15 causes the resin film 15 to make closer contact with the electronic component 13 and the mounting substrate 11.

In the case where the resin film 15 is sufficiently flexible under a room temperature, the resin film 15 may be deformed under the room temperature to fix the shape, and then the resin film 15 may be heated up for curing.

Alternatively, the resin film 15 may be softened and shaped under a temperature not exceeding the glass transition temperature, and gradually cured under the temperature not exceeding the glass transition temperature over a relatively long period of time.

In the case where the resin film 15 is made of a resin that can be softened with an ultraviolet ray, the resin film 15 may be irradiated with the ultraviolet ray for softening, instead of being heated up. Also, the resin film 15 may be both heated and irradiated with the ultraviolet ray, for softening.

Likewise, in the case where the resin film 15 is made of a resin that can be cured with an ultraviolet ray, the resin film 15 may be irradiated with the ultraviolet ray for curing, instead of being heated up. Also, the resin film 15 may be both heated and irradiated with the ultraviolet ray, for curing.

If necessary, the resin film 15 may be heated again up to 150°C after the curing process, and an epoxy resin may be provided over the resin film 15 and pressed against the resin film 15 with a flat tool from an upper direction, and then thermally cured so as to form the outer coating resin 17, in order to enhance the overall mechanical strength and planarize the protrusion of the electronic component 13, thereby facilitating the mounting process performed by an automatic mounting equipment (Fig. 3A). Finally, the collective substrate 11c is cut by a dicing saw or a laser cutter, so that the plurality of electronic components 13 is separated from each other. Through the foregoing process, the electronic device 10 shown in Fig. 1 can be obtained (Fig. 3B).

This embodiment offers the following advantageous effects. The micro processing of removing the once adhered resin film in a stripe pattern, which is the drawback of the electronic device shown in Fig. 6, is no longer necessary because of the enhanced close contact between the resin film 15 and the mounting substrate 11. The conventional laminating technique does not focus on the adhesion strength between the film and the substrate, but cures the synthetic resin fluid laid over the film including the substrate surface exposed where the film has been removed in stripes, to thereby firmly fix the film and the substrate. In this embodiment, however, the outer coating resin 17 covering the upper surface of the resin film 15 is provided only when necessary to rectify the shape of the electronic device 10 and increase the mechanical strength thereof, and the resin film 15 itself is already closely bonded to the mounting substrate 11 with sufficient strength. In order to secure the sufficient strength, the thickness and nature of the material of the resin film 15, as well as the pressure and temperature to be employed when pressing the resin film 15 against the mounting substrate 11 have been specified.

Here, description will be made regarding the relationship between the characteristic of the resin film 15 and the hollowness and air-tightness of the electronic device 10. Regarding the nature of the resin film, it has been discovered that controlling "shear viscosity" and "flow length" is effective in the transition of state from a film to a thermally cured resin via a fluidized state, through investigation on the relationship between various physical constants, such as glass transition point, thixotropic index and viscosity, and package formation performance. The "shear viscosity" represents a measured value of a rotational shearing stress of a resin film, generated when the film is held between two flat plates and a momentum is applied to one of the plates. When the shear viscosity value is greater, the film is less prone to melt so as to flow into the space between the electronic component and the substrate, which facilitates stably forming the hollow space. In case where the shear viscosity is excessively high, however, once the film melts and adheres to the substrate the resin becomes difficult to be separated from the susbstrate, thereby degrading the closeness of the adhesion. It is because, unless the viscosity of the film is lower than a certain level, minute gaps may be created to thereby degrade the air-tightness of the package.

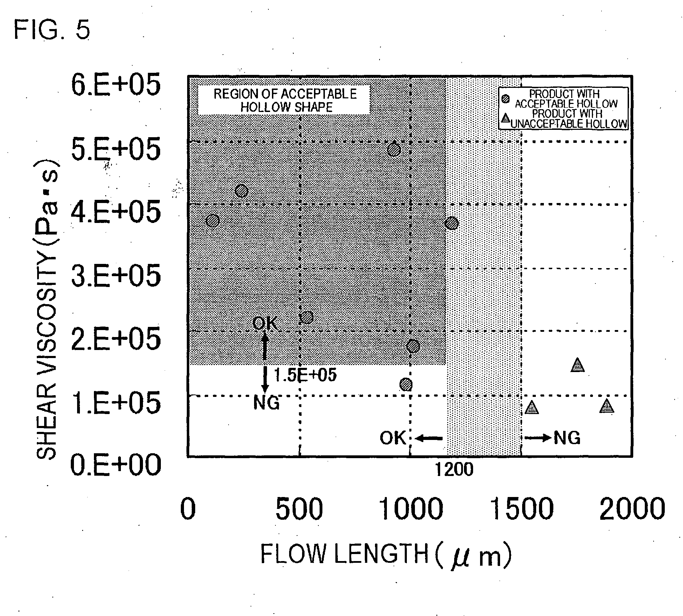

The index that specifies the upper limit is the "flow length". The flow length represents a measured value of the length of a portion of a film that has expanded from its initial shape, when the film of a predetermined size is held between flat plates and pressed thus to be deformed. It is known that a film of a shorter flow length provides inferior air-tightness of the package after forming a hollow space. The air-tightness can be evaluated by dipping the package in a special fluid and observing the invasion of the fluid. Based on the evaluation by fluorescent X-ray irradiation of dipped packages, it has been discovered that sufficient air-tightness can be secured when the flow length is 100 µm or longer. In order to secure a completely hollow state and sufficient package strength, therefore, it is necessary to employ a resin film having a shear viscosity equal to or more than 100 kPa·s and equal to or less than 1000 kPa·s at the temperature of 50 degrees centigrade, and a flow length equal to or more than 100 µm and equal to or less than 1500 µm at the temperature of 50 degrees centigrade, and more preferably a resin film having a shear viscosity equal to or more than 150 kPa·s and equal to or less than 600 kPa·s at the temperature of 50 degrees centigrade and a flow length equal to or more than 100 µm and equal to or less than 1200 µm at the temperature of 50 degrees centigrade. The appropriate ranges of the shear viscosity at the temperature of 50 degrees centigrade and the flow length at the temperature of 50 degrees centigrade are shown in Fig. 5.

Referring to the thickness of the resin film 15, in case where the resin film 15 is too thick it is difficult to properly cover the electronic component 13 when the interval between the electronic components 13 is narrow or when the electronic component 13 is relatively thick. On the contrary, in case where the resin film 15 is too thin, the resin film is prone to be torn. From such viewpoint, when the electronic component 13 has a thickness of approx. 0.5 to 1 mm for example, it is preferable that the resin film 15 has a thickness of approx. 0.15 mm.

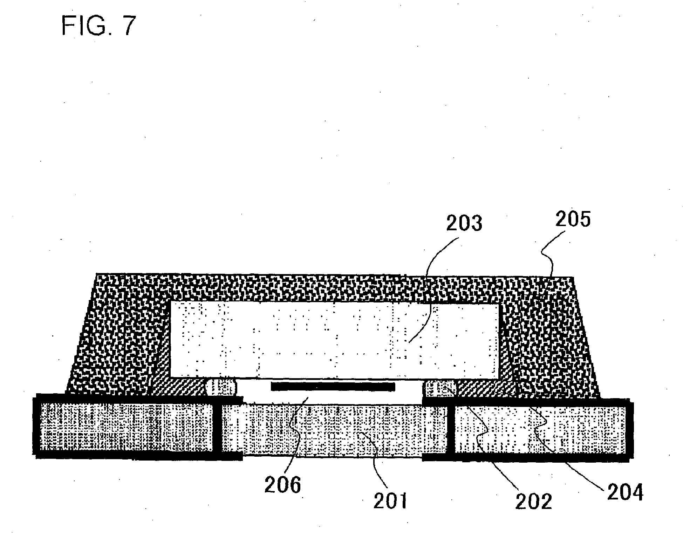

Meanwhile, in an electronic device disclosed in the patented document 2 as shown in Fig. 7, an electronic component 203 is mounted on a substrate 201 by a flip-chip technique utilizing a bump 202. Around the bump 202 on the substrate 201, a resin layer 204 is provided. Further, a resin layer 205 is provided so as to cover the electronic component 203 and the resin layer 204. The resin layer 205 is lower in viscosity than the resin layer 204. In such electronic device, the resin layer 204 having relatively higher viscosity serves as a wall that air-tightly seals a space 206 between an electrode of the electronic component 203 and the substrate 201. The presence of the resin layer 204 prevents the resin of the lower viscosity to be subsequently applied (the resin constituting the resin layer 205) from intruding into the space 206, thereby securing the air-tightness.

Such structure including the resin layer 204 of relatively high viscosity serving as the wall to secure the air-tightness, instead of a film-shape synthetic resin, is free from a special micro processing and a special processing equipment for application of the resin. To air-tightly seal the space 206, however, it is necessary that the resin layer 204 has both appropriate hardness that inhibits intrusion into the space 206 and appropriate softness that allows achieving close contact thereby assuring complete sealing effect, at a time. Such condition largely depends on the characteristic of the resin layer 204 and the application condition thereof, and hence it is quite difficult to determine the condition that enables constantly achieving the air-tight sealing effect. Besides, employing two types of thermosetting resins having different characteristics in an assembly process leads to relatively longer handling time per piece and an increase in number of curing operations which require strict temperature control, thereby incurring greater trouble in processing.

The disadvantage originating from the difficulty of constantly securing an air-tightly sealed space between a chip and the substrate, utilizing two types of thermosetting resins having different viscosities, is eliminated in this embodiment, by specifying the film thickness and the nature of the material, as well as the pressure and temperature under which the film is to be pressed against the substrate. Generally, the adhesion strength between the film and the mounting substrate and air-tight sealing performance with respect to the space between the chip and the substrate are contradictory requirements in setting the manufacturing condition. Employing a sufficiently soft film to achieve closer contact may lead to intrusion of the resin into the space, but employing an excessively hard film may lead to insufficient adhesion strength. Thus, this embodiment provides the optimal conditions by materials and processing methods.

As described above, the foregoing embodiment enables mass-producing a plurality of air-tightly sealed electronic devices at a lower cost and in a shorter time, by covering those electronic devices with a single sheet of resin film. Also, the foregoing embodiment provides the characteristic and shape of the resin material and assembly condition that can stably achieve the air-tight sealing effect.

It is apparent that the present invention is not limited to the above embodiment, and may be modified and changed without departing from the scope and spirit of the invention.

## Claims

1. An electronic device comprising:
a substrate;
an electronic component mounted on said substrate; and
a resin film provided over an entirety of said substrate so as to cover said electronic component;
wherein said resin film has a shear viscosity equal to or more than 100 kPa·s and equal to or less than 1000 kPa·s at the temperature of 50 degrees centigrade, and a flow length equal to or more than 100 µm and equal to or less than 1500 µm at the temperature of 50 degrees centigrade.

2. The electronic device according to claim 1,
wherein a plurality of said electronic components is mounted on said substrate; and
said resin film collectively covers said plurality of said electronic components.

3. The electronic device according to claim 1,
wherein an upper surface of said resin film includes a protruding portion at a position corresponding to said electronic component.

4. The electronic device according to claim 1, further comprising:
a resin layer provided on said resin film.

5. The electronic device according to claim 4,
wherein an upper surface of said resin layer is flat.

6. A method of manufacturing an electronic device, comprising:
mounting an electronic component on a substrate;
providing a resin film over an entirety of said substrate so as to cover said electronic component;
wherein said providing a resin film includes employing a resin film having a shear viscosity equal to or more than 100 kPa·s and equal to or less than 1000 kPa·s at the temperature of 50 degrees centigrade, and a flow length equal to or more than 100 µm and equal to or less than 1500 µm at the temperature of 50 degrees centigrade.

7. The method according to claim 6,
wherein said mounting an electronic component includes mounting a plurality of said electronic components on said substrate; and
said providing a resin film includes providing said resin film so as to collectively cover said plurality of said electronic component.

8. The method according to claim 7, further comprising:
cutting said substrate so as to separate said plurality of said electronic components from each other, after said providing a resin film.

9. The method according to claim 6, further comprising:
forming a resin layer on said resin film.
